# EUROPEAN PATENT APPLICATION

(11) **EP 4 660 850 A1**
(43) Date of publication of application: **10.12.2025**
(21) Application number: 23923886.8
(22) Date of filing: 27.12.2023
(51) Int. Cl.: G06F 18/214

(54) **MODEL TRAINING METHOD AND APPARATUS, AND STORAGE MEDIUM**

(30) Priority: 21.02.2023 CN 202310145883; 06.05.2023 CN 202310504921
(71) Applicant: Huawei Cloud Computing Technologies Co., Ltd., Guiyang, Guizhou 550025 (CN)
(72) Inventor: MAO, Sitong, Guiyang, Guizhou 550025 (CN); RAO, Zhongwen, Guiyang, Guizhou 550025 (CN); ZHOU, Shunbo, Guiyang, Guizhou 550025 (CN); WANG, Feng, Guiyang, Guizhou 550025 (CN)
(74) Representative: Pfenning, Meinig & Partner mbB
(86) International application number: PCT/CN2023/142498
(87) International publication number: WO 2024/174723

(57) **Abstract**

A model training method and apparatus, and a storage medium are provided, and pertain to the computer field. The method includes: obtaining a plurality of pieces of real data and a plurality of pieces of first simulation data, where the plurality of pieces of real data are data describing a real environment, the real environment is an environment to which a to-be-trained first artificial intelligence AI model is applied, the plurality of pieces of first simulation data are data describing a simulation environment, and the simulation environment is used to simulate the real environment; adjusting the plurality of pieces of first simulation data based on the plurality of pieces of real data to obtain a plurality of pieces of second simulation data; and performing model training based on the plurality of pieces of real data and the plurality of pieces of second simulation data to obtain the first AI model. In this way, accuracy of training an AI model can be improved.

## Description

This application claims priority to Chinese Patent Application No. 202310145883.4, filed on February 21, 2023 and entitled "SIMULATION-BASED EDGE-CLOUD COLLABORATIVE MULTI-MODAL PERCEPTION METHOD AND APPARATUS, AND STORAGE MEDIUM", which is incorporated herein by reference in its entirety. In addition, this application claims priority to Chinese Patent Application No. 202310504921.0, filed on May 6, 2023 and entitled "MODEL TRAINING METHOD AND APPARATUS, AND STORAGE MEDIUM", which is incorporated herein by reference in its entirety.

### TECHNICAL FIELD

This application relates to the computer field, and in particular, to a model training method and apparatus, and a storage medium.

### BACKGROUND

An artificial intelligence (artificial intelligence, AI) technology is widely applied to automobile, robot, city construction, healthcare, and other industries. For example, in the automobile industry, an AI model used to implement autonomous driving is trained, and autonomous driving of an automobile is implemented by using the AI model. Before training, a large amount of training data is obtained, and then training is performed based on the large amount of training data to obtain the AI model.

In a related technology, a sensor device is used for collection in a real environment to obtain real data, and the real data is used as training data. The real environment is an environment to which the AI model is applied. However, it is difficult to collect a large amount of real data by using the sensor device, and usually, only a small amount of real data can be collected. Therefore, a simulation environment may be established, a large amount of simulation data is generated based on the simulation environment, and the large amount of simulation data is also used as training data. Then, training is performed based on the small amount of real data and the large amount of simulation data to obtain an AI model.

Although the AI model may be obtained through training based on the small amount of real data and the large amount of simulation data, accuracy of the AI model obtained through training is usually low.

### SUMMARY

This application provides a model training method and apparatus, and a storage medium, to improve accuracy of training an AI model. The technical solutions are as follows:

According to a first aspect, this application provides a model training method. The method is applied to a cloud service platform. The method includes: obtaining a plurality of pieces of real data and a plurality of pieces of first simulation data, where the plurality of pieces of real data are data describing a real environment, the real environment is an environment to which a to-be-trained first artificial intelligence AI model is applied, the plurality of pieces of first simulation data are data describing a simulation environment, and the simulation environment is used to simulate the real environment; adjusting the plurality of pieces of first simulation data based on the plurality of pieces of real data to obtain a plurality of pieces of second simulation data; and performing model training based on the plurality of pieces of real data and the plurality of pieces of second simulation data to obtain the first AI model.

Because the plurality of pieces of first simulation data are adjusted based on the plurality of pieces of real data to obtain the plurality of pieces of second simulation data, and model training is performed based on the plurality of pieces of real data and the plurality of pieces of second simulation data to obtain the first AI model, accuracy of the first AI model obtained through training can be improved.

In a possible implementation, the plurality of pieces of second simulation data are closer to the data describing the real environment than the plurality of pieces of first simulation data. In this way, the plurality of pieces of second simulation data are used to train the first AI model, thereby improving accuracy of training the first AI model.

In another possible implementation, the plurality of pieces of real data include at least one piece of first data and at least one piece of second data. The plurality of pieces of first simulation data are adjusted based on the at least one piece of second data to obtain the plurality of pieces of second simulation data. Model training is performed based on the at least one piece of first data and the plurality of pieces of first simulation data to obtain a second AI model. The second AI model is adjusted based on the at least one piece of second data and the plurality of pieces of second simulation data to obtain the first AI model. Because the plurality of pieces of first simulation data are adjusted based on the at least one piece of second data to obtain the plurality of pieces of second simulation data, and then the second AI model is adjusted based on the at least one piece of second data and the plurality of pieces of second simulation data to obtain the first AI model, the first AI model with high accuracy can be obtained.

In another possible implementation, the simulation environment is created based on the plurality of pieces of real data, and the plurality of pieces of first simulation data are generated based on the simulation environment. Because the simulation environment is created based on the plurality of pieces of real data, accuracy of the simulation environment can be improved. In this way, the first simulation data with high accuracy can be generated.

In another possible implementation, a first adjustment model is obtained based on the at least one piece of second data and the plurality of pieces of first simulation data. The first adjustment model is used to adjust a visual characteristic of simulation data toward a visual characteristic of the data describing the real environment. Visual characteristics of the plurality of pieces of first simulation data are adjusted based on the first adjustment model to obtain the plurality of pieces of second simulation data. Because the first adjustment model is used to adjust the visual characteristic of the simulation data toward the visual characteristic of the data describing the real environment, the visual characteristics of the plurality of pieces of first simulation data are adjusted based on the first adjustment model to obtain the plurality of pieces of second simulation data, so that visual characteristics of the plurality of pieces of second simulation data are closer to the visual characteristic of the data describing the real environment.

In another possible implementation, the visual characteristics of the plurality of pieces of first simulation data are adjusted based on a second adjustment model to obtain a plurality of pieces of third simulation data. A first type of data included in a first data set is determined based on a first discriminator network. The first type indicates whether the data is real data or simulation data, and the first data set includes the at least one piece of second data and the plurality of pieces of third simulation data. A network parameter of the second adjustment model is adjusted based on the first type of the data included in the first data set to obtain a third adjustment model. When the third adjustment model meets a first condition, the third adjustment model is determined as the first adjustment model. In this way, the first AI model that adjusts the visual characteristic of the simulation data toward the visual characteristic of the data describing the real environment can be trained.

In another possible implementation, when the third adjustment model does not meet the first condition, a network parameter of the first discriminator network is adjusted based on a second type of the at least one piece of second data and the first type of the data included in the first data set to obtain a second discriminator network. The second type indicates that the at least one piece of second data is real data. The visual characteristics of the plurality of pieces of first simulation data are adjusted based on the third adjustment model to obtain a plurality of pieces of fourth simulation data. A first type of data included in a second data set is determined based on the second discriminator network. The second data set includes the at least one piece of second data and the plurality of pieces of fourth simulation data. A network parameter of the third adjustment model is adjusted based on the first type of the data included in the second data set to obtain a fourth adjustment model. When the fourth adjustment model meets the first condition, the fourth adjustment model is determined as the first adjustment model. In this way, an adjustment model may be cyclically trained to obtain the first adjustment model with high accuracy.

In another possible implementation, a network parameter of the second AI model is adjusted based on the at least one piece of second data and the plurality of pieces of second simulation data to obtain a third AI model. Features that are of the plurality of pieces of second simulation data and that are extracted based on the third AI model are closer to a feature of the at least one piece of second data than features that are of the plurality of pieces of second simulation data and that are extracted based on the second AI model. A network parameter of the third AI model is adjusted based on a third data set and label information of data in the third data set to obtain the first AI model. The third data set includes the at least one piece of second data and the plurality of pieces of second simulation data. Because the features that are of the plurality of pieces of second simulation data and that are extracted based on the third AI model are closer to the feature of the at least one piece of second data than the features that are of the plurality of pieces of second simulation data and that are extracted based on the second AI model, the third AI model is adjusted to obtain the first AI model. In this way, accuracy of the first AI model can be improved.

In another possible implementation, the feature of at least one piece of second data and the features of the plurality of pieces of second simulation data are extracted based on the second AI model. The network parameter of the second AI model is adjusted based on the feature of the at least one piece of second data and the features of the plurality of pieces of second simulation data to obtain the third AI model. In this way, the features that are of the plurality of pieces of second simulation data and that are extracted based on the third AI model are closer to the feature of the at least one piece of second data than the features that are of the plurality of pieces of second simulation data and that are extracted based on the second AI model.

In another possible implementation, the plurality of pieces of second simulation data are annotated to obtain label information of the plurality of pieces of second simulation data. Some second data in the at least one piece of second data is annotated to obtain label information of the some second data. The feature of the at least one piece of second data and the features of the plurality of pieces of second simulation data are extracted based on the second AI model, the label information of the some second data, and the label information of the plurality of pieces of second simulation data.

In another possible implementation, the label information of the data in the third data set includes label information of the at least one piece of second data and label information of the plurality of pieces of second simulation data. Inference is performed on the at least one piece of second data based on the third AI model to obtain the label information of the at least one piece of second data. The plurality of pieces of second simulation data are annotated based on a multi-modal model to obtain the label information of the plurality of pieces of second simulation data.

In another possible implementation, at least one piece of real data and label information of the at least one piece of real data that are sent by a terminal device are received. The terminal device is located in the real environment, the at least one piece of real data is data collected by the terminal device in the real environment, and the label information of the at least one piece of real data is obtained by the terminal device by performing inference on the at least one piece of truth data based on the first AI model. The first AI model is adjusted based on the at least one piece of real data and the label information of the at least one piece of real data. In this way, after the first AI model is trained, feedback of running the first AI model by the terminal device may be continuously received, and the first AI model is continuously optimized based on the received feedback, to continue to improve accuracy of the first AI model.

In another possible implementation, the plurality of pieces of real data include one or more of the following data: image data, radar data, object point cloud data, or object inertial measurement unit IMU data. The plurality of pieces of real data may be data in 3D space, and may be applied to a real environment of the 3D space.

According to a second aspect, this application provides a model training apparatus, configured to perform the method according to any one of the first aspect or the possible implementations of the first aspect. Specifically, the apparatus includes units configured to perform the method according to any one of the first aspect or the possible implementations of the first aspect.

According to a third aspect, this application provides a computing device cluster. The computing device cluster includes at least one computing device, and each device in the at least one computing device includes at least one processor and at least one memory. The at least one memory stores computer-readable instructions, and the at least one processor executes the computer-readable instructions, so that the computing device cluster performs the method according to any one of the first aspect or the possible implementations of the first aspect.

According to a fourth aspect, this application provides a computer program product. The computer program product includes a computer program stored in a computer-readable storage medium, and the computer program is loaded by a processor to implement the method according to any one of the first aspect or the possible implementations of the first aspect.

According to a fifth aspect, this application provides a computer-readable storage medium, configured to store a computer program. The computer program is loaded by a processor to perform the method according to any one of the first aspect or the possible implementations of the first aspect.

According to a sixth aspect, this application provides a chip, including a memory and a processor. The memory is configured to store computer instructions, and the processor is configured to invoke the computer instructions from the memory and run the computer instructions, to perform the method according to any one of the first aspect or the possible implementations of the first aspect.

### BRIEF DESCRIPTION OF THE DRAWINGS

FIG. 1 is a diagram of a network architecture according to an embodiment of this application;
FIG. 2 is a diagram of another network architecture according to an embodiment of this application;
FIG. 3 is a flowchart of a model training method according to an embodiment of this application;
FIG. 4 is a flowchart of a method for obtaining a first adjustment model according to an embodiment of this application;
FIG. 5 is a flowchart of a method for obtaining a third AI model according to an embodiment of this application;
FIG. 6 is a flowchart of another method for obtaining a third AI model according to an embodiment of this application;
FIG. 7 is a flowchart of a method for obtaining a first AI model according to an embodiment of this application;
FIG. 8 is a flowchart of another model training method according to an embodiment of this application;
FIG. 9 is a diagram of a structure of a model training apparatus according to an embodiment of this application;
FIG. 10 is a diagram of a structure of a computing device according to an embodiment of this application;
FIG. 11 is a diagram of a structure of a computing device cluster according to an embodiment of this application; and
FIG. 12 is a diagram of a structure of another computing device cluster according to an embodiment of this application.

### DESCRIPTION OF EMBODIMENTS

The following further describes in detail implementations of this application with reference to the accompanying drawings.

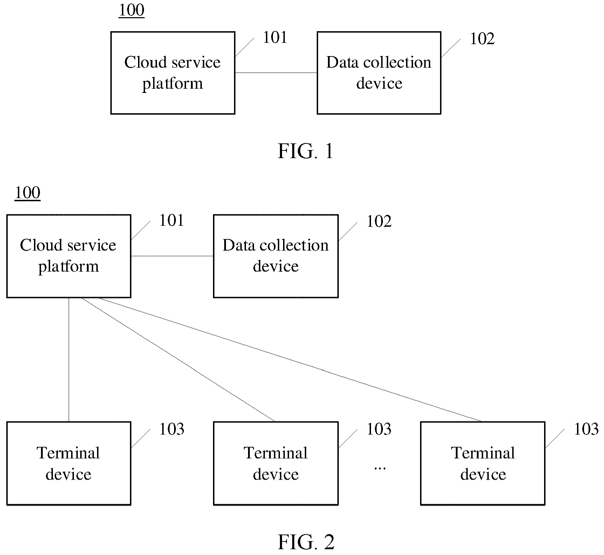

With reference to FIG. 1, an embodiment of this application provides a network architecture 100. The network architecture 100 includes a cloud service platform 101 and a data collection device 102. The cloud service platform 101 communicates with the data collection device 102.

The network architecture 100 is used to train an AI model, so that the AI model has a function required by a user. For ease of description, an environment to which the AI model is applied is referred to as a real environment, and data in the real environment is referred to as real data.

For example, it is assumed that an AI model with a function of recognizing an object in an industrial campus needs to be trained, and the industrial campus is a real environment. Data collected in the industrial campus is referred to as real data. Optionally, the real data may be one or more of the following: image data, radar data, object point cloud data, object inertial measurement unit (inertial measurement unit, IMU) data, or the like. The data is collected in the industrial campus to obtain the real data. The AI model is used to perform inference on the real data in the industrial campus, to recognize the object in the industrial campus.

The data collection device 102 is located in the real environment, and is configured to: collect data in the real environment to obtain a plurality of pieces of real data; where the plurality of pieces of real data are data describing the real environment; and send the plurality of pieces of real data to the cloud service platform 101.

The cloud service platform 101 is configured to: receive the plurality of pieces of real data; obtain a plurality of pieces of first simulation data, where the plurality of pieces of first simulation data are data describing a simulation environment, and the simulation environment is used to simulate the real environment; adjust the plurality of pieces of first simulation data based on the plurality of pieces of real data to obtain a plurality of pieces of second simulation data, where the plurality of pieces of second simulation data are closer to the data describing the real environment than the plurality of pieces of first simulation data; and perform model training based on the plurality of pieces of real data and the plurality of pieces of second simulation data to obtain a first AI model.

In some embodiments, the cloud service platform 101 may: perform model training based on at least one piece of first data and the plurality of pieces of first simulation data to obtain a second AI model, where the at least one piece of first data is some data in the plurality of pieces of real data; adjust the plurality of pieces of first simulation data based on at least one piece of second data to obtain the plurality of pieces of second simulation data, where the at least one piece of second data is data other than the at least one piece of first data in the plurality of pieces of real data; and adjust the second AI model based on the at least one piece of second data and the plurality of pieces of second simulation data to obtain the first AI model.

In some embodiments, with reference to FIG. 2, the network architecture 100 further includes at least one terminal device 103, the cloud service platform 101 further communicates with each terminal device 103, and the at least one terminal device 103 is also located in the real environment.

After the cloud service platform 101 obtains the first AI model through training, the cloud service platform 101 may deploy the first AI model on each of the at least one terminal device 103.

For each of the at least one terminal device 103, the terminal device 103 is configured to: collect data in the real environment to obtain at least one piece of real data, and perform inference on the at least one piece of real data based on the first AI model.

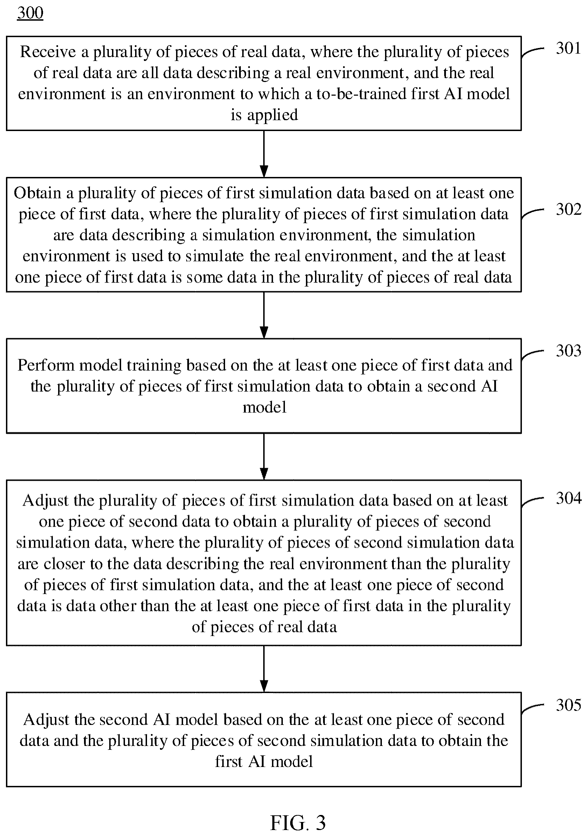

With reference to FIG. 3, an embodiment of this application provides a model training method 300. The method 300 is applied to the network architecture 100 shown in FIG. 1 or FIG. 2. The method 300 includes the following steps.

Step 301: Receive a plurality of pieces of real data, where the plurality of pieces of real data are all data describing a real environment, and the real environment is an environment to which a to-be-trained first AI model is applied.

When a data collection device located in the real environment needs to train an AI model with a specific function, the data collection device collects the plurality of pieces of real data in the real environment, and sends the plurality of pieces of real data to a cloud service platform. The real environment is an environment to which the AI model is applied.

In some embodiments, the data collection device includes one or more of the following devices: a camera device, a radar device, an IMU, or the like.

In some embodiments, the plurality of pieces of real data include one or more of the following data: image data, radar data, object point cloud data, object IMU data, or the like. The image data or the object point cloud data is obtained by the camera device by photographing the real environment, the radar data is obtained by the radar device through collection in the real environment, and the object IMU data is obtained by the IMU by collecting an object in the real environment.

In some embodiments, the data collection device may further send a training task to the cloud service platform, and the training task is used to request to train the AI model that implements the function in the real environment.

In some embodiments, the data collection device further annotates each of the plurality of pieces of real data to obtain label information of each piece of real data, and further sends the label information of each piece of real data to the cloud service platform.

The plurality of pieces of real data are data required for training the AI model. For any one of the plurality of pieces of real data, the real data and label information of the real data may constitute a training sample, and the training sample is used to train the AI model.

For any piece of real data, label information of the real data indicates a target in the real data. For example, it is assumed that an AI model for object recognition needs to be trained. Then, the label information of the real data may be object identification information in the real data, and the object identification information may be an object category or an object name. For another example, it is assumed that an AI model for semantic segmentation needs to be trained. Then, the AI model is used to segment an object from data, and the label information of the real data may be an object boundary in the real data.

For example, it is assumed that an AI model with an object recognition function needs to be trained. Then, the AI model is used to recognize an object in an industrial campus, and the data collection device is a camera device. The data collection device is located in the industrial campus, and is configured to: photograph an object in the industrial campus to obtain a plurality of pieces of image data, a plurality of pieces of object point cloud data, and the like. An object image in each piece of image data is annotated to obtain label information of each piece of image data. For each piece of image data, the label information of the image data may be object identification information (for example, which may be an object name or an object category) in the image data. It is assumed that the image data includes an apple image. Then, the label information of the image data may be an apple. A point that belongs to an object and that is in each piece of object point cloud data is annotated to obtain label information of each piece of object point cloud data. For each piece of object point cloud data, the label information of the object point cloud data may be object identification information (for example, which may be an object name or an object category).

The data collection device sends the plurality of pieces of image data, the plurality of pieces of object point cloud data, the label information of the plurality of pieces of image data, the label information of the plurality of pieces of object point cloud data, and a training task to the cloud service platform. The training task is used to request to train an AI model that has an object recognition function in the industrial campus.

Step 302: Obtain a plurality of pieces of first simulation data based on at least one piece of first data, where the plurality of pieces of first simulation data are data describing a simulation environment, the simulation environment is used to simulate the real environment, and the at least one piece of first data is some data in the plurality of pieces of real data.

The plurality of pieces of first simulation data are also data required for training the AI model. If a large quantity of data collection devices are deployed in the real environment to collect a large amount of real data, it is difficult and costly. Therefore, the real environment may be simulated to obtain the simulation environment, and a large amount of first simulation data is obtained based on the simulation environment.

In step 302, the plurality of pieces of first simulation data may be obtained by performing the following procedures 3021 and 3022.

3021: Create the simulation environment based on the at least one piece of first data.

In 3021, the simulation environment may be created in the following two manners.

Manner 1: Obtain, based on the at least one piece of first data, each simulation component corresponding to the simulation environment and posture information and location information of each simulation component, and generate the simulation environment based on each simulation component corresponding to the simulation environment and the posture information and the location information of each simulation component.

In Manner 1, identification information of the real environment is obtained based on the at least one piece of first data and an environment recognition model, and each simulation component corresponding to the real environment is obtained based on an asset library and a type of the real data. Posture information and location information of each simulation component corresponding to the real environment are obtained based on object point cloud data included in the at least one piece of first data. Based on the posture information and the location information of each simulation component, each simulation component is constructed into the simulation environment.

The asset library is used to store a correspondence between the identification information of the real environment and the simulation component.

The environment recognition model is obtained through training by using a plurality of first training samples, and each first training sample includes identification information of a real environment and at least one piece of real data that belongs to the real environment. Alternatively, the environment recognition model is an existing model with an environment recognition function.

In some embodiments, corresponding simulation components are obtained from the asset library based on the identification information of the real environment, and the obtained simulation components are displayed, so that a user selects each simulation component corresponding to the real environment. For any simulation component, object point cloud data corresponding to the simulation component is obtained from the at least one piece of first data. The simulation component and the object point cloud data correspond to a same object, and the object point cloud data includes location information of a plurality of points on an object corresponding to the simulation component, and the like. Posture information and location information of the simulation component are obtained based on the object point cloud data.

For example, a plurality of pieces of image data and a plurality of pieces of object point cloud data that are sent by the data collection device are received, and identification information that is of a real environment and that is obtained based on the plurality of pieces of image data, the plurality of pieces of object point cloud data, and the environment recognition model is an industrial campus. Simulation components corresponding to the industrial campus are obtained from the asset library, and the obtained simulation components include at least one building simulation component, at least one road simulation component, at least one automobile simulation component, at least one flowerbed simulation component, and the like.

The at least one building simulation component, the at least one road simulation component, the at least one automobile simulation component, the at least one flowerbed simulation component, and/or the like are/is displayed, so that the user selects a building simulation component, a road simulation component, an automobile simulation component, a flowerbed simulation component, and/or the like corresponding to the industrial campus.

Posture information and location information of the building simulation component corresponding to the industrial campus are obtained based on building point cloud data included in the at least one piece of first data. Posture information and location information of the road simulation component corresponding to the industrial campus are obtained based on road point cloud data included in the at least one piece of first data. Posture information and location information of the automobile simulation component corresponding to the industrial campus are obtained based on automobile point cloud data included in the at least one piece of first data. Posture information and location information of the flowerbed simulation component corresponding to the industrial campus are obtained based on flowerbed point cloud data included in the at least one piece of first data.

The building simulation component, the road simulation component, the automobile simulation component, the flowerbed simulation component, and/or the like corresponding to the industrial campus are/is constructed into a simulation environment of the industrial campus based on the posture information and the location information of the building simulation component, the posture information and the location information of the road simulation component, the posture information and the location information of the automobile simulation component, the posture information and the location information of the flowerbed simulation component, and/or the like corresponding to the industrial campus.

Manner 2: Obtain label information of the at least one piece of first data, and generate the simulation environment based on the at least one piece of first data and the label information of the at least one piece of first data.

In Manner 2, if the data collection device sends the label information of the at least one piece of first data, the received label information of the at least one piece of first data is obtained.

If the data collection device does not send the label information of the at least one piece of first data, the at least one piece of first data is annotated based on a multi-modal model to obtain the label information of the at least one piece of first data. To be specific, for any piece of first data, the first data is input into the multi-modal model, so that the multi-modal model annotates the first data to obtain label information of the first data. In this way, the label information that is of the first data and that is output by the multi-modal model is obtained.

In Manner 2, the simulation environment is generated based on the at least one piece of first data and the label information of the at least one piece of first data by using an algorithm used to create a simulation environment. Optionally, the algorithm used to create the simulation environment includes one or more of the following algorithms: a simultaneous localization and mapping (simultaneous localization and mapping, SLAM) algorithm, a visual simultaneous localization and mapping (visual simultaneous localization and mapping, VSLAM) algorithm, a radar-based SLAM algorithm, and the like.

3022: Generate the plurality of pieces of first simulation data based on the simulation environment.

In 3022, the plurality of pieces of first simulation data are generated based on the simulation environment by using a simulation data generation tool. Optionally, the simulation data generation tool includes one or more of the following tools: Blender (which is a software name) or NVIDIA Omniverse Replicator (which is a software name).

Step 303: Perform model training based on the at least one piece of first data and the plurality of pieces of first simulation data to obtain a second AI model.

In step 303, the plurality of pieces of first simulation data are annotated based on the multi-modal model to obtain label information of the plurality of pieces of first simulation data. The plurality of pieces of first simulation data and the label information of the plurality of pieces of first simulation data constitute a plurality of second training samples. Each of the plurality of second training samples includes one piece of first simulation data and label information of the piece of first simulation data. The at least one piece of first data and the label information of the at least one piece of first data constitute at least one second training sample. Each of the at least one second training sample includes one piece of first data and label information of the piece of first data. Model training is performed based on each constituted second training sample to obtain the second AI model.

In some embodiments, model training is performed on a blank model based on each constituted second training sample to obtain the second AI model. Optionally, the blank model may be a convolutional neural network, a random forest algorithm, a logistic regression algorithm, a support vector machine (support vector machine, SVM), or the like.

In some embodiments, the training task indicates a function, and an AI model with the function is obtained. An environment to which the AI model is applied is different from the real environment. Model training is performed, based on each constituted second training sample, on the obtained AI model to obtain the second AI model.

For example, for an existing AI model used to recognize an object in an industrial campus, the AI model may not be applicable to a new industrial campus after change due to a change in a layout and/or an object of the industrial campus. Therefore, training may be performed based on the AI model to obtain a model that is applicable to the new industrial campus after change.

The plurality of pieces of first simulation data are generated based on the simulation environment. Therefore, there is a large difference between the plurality of pieces of first simulation data and the data used to describe the real environment, and accuracy of the second AI model obtained through training is not high enough. Therefore, the following operations need to be performed to adjust the plurality of pieces of first simulation data.

Step 304: Adjust the plurality of pieces of first simulation data based on at least one piece of second data to obtain a plurality of pieces of second simulation data, where the plurality of pieces of second simulation data are closer to the data of the real environment than the plurality of pieces of first simulation data, and the at least one piece of second data is data other than the at least one piece of first data in the plurality of pieces of real data.

In some embodiments, there is a large difference between visual characteristics of the plurality of pieces of first simulation data and a visual characteristic of the data used to describe the real environment. Optionally, the visual characteristic of first simulation data includes one or more of the following characteristics: texture, illumination, an object image shape, or the like of the first simulation data.

In step 304, the plurality of pieces of first simulation data may be adjusted by performing the following operations in 3041 and 3042 to obtain the plurality of pieces of second simulation data.

3041: Obtain a first adjustment model based on the at least one piece of second data and the plurality of pieces of first simulation data, where the first adjustment model is used to adjust a visual characteristic of simulation data toward the visual characteristic of the data of the real environment.

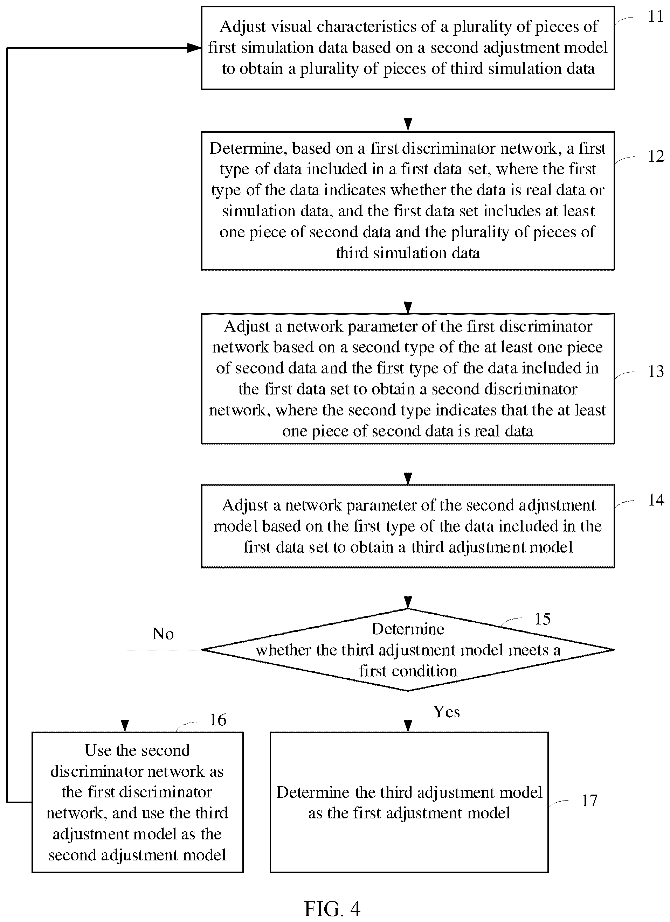

In some embodiments, with reference to FIG. 4, the first adjustment model is obtained by performing the following procedures.

11: Adjust the visual characteristics of the plurality of pieces of first simulation data based on a second adjustment model to obtain a plurality of pieces of third simulation data.

The second adjustment model may be a convolutional neural network, a random forest algorithm, a logistic regression algorithm, an SVM, or the like.

In the operation 11, the plurality of pieces of first simulation data are input into the second adjustment model, so that the second adjustment model adjusts the visual characteristics of the plurality of pieces of first simulation data to obtain the plurality of pieces of third simulation data. In this way, the plurality of pieces of third simulation data output by the second adjustment model are obtained.

In some embodiments, for any piece of first simulation data, the second adjustment model adjusts a visual characteristic of the piece of first simulation data to obtain one piece of third simulation data. To be specific, the second adjustment model adjusts the visual characteristic of the piece of first simulation data in terms of texture, illumination, an object image shape, or the like to obtain the piece of third simulation data.

12: Determine, based on a first discriminator network, a first type of data included in a first data set, where the first type of the data indicates whether the data is real data or simulation data, and the first data set includes the at least one piece of second data and the plurality of pieces of third simulation data.

In the operation 12, the data included in the first data set is input into the first discriminator network. For each piece of data included in the first data set, the first discriminator network determines a type of the data. The type that is of each piece of data included in the first data set and that is output by the first discriminator network is obtained.

13: Adjust a network parameter of the first discriminator network based on a second type of the at least one piece of second data and the first type of the data included in the first data set to obtain a second discriminator network, where the second type indicates that the at least one piece of second data is real data.

In the operation 13, the at least one piece of second data is some data in the plurality of pieces of real data. Therefore, it may be directly determined that the second type of the at least one piece of second data indicates that the at least one piece of second data is real data.

14: Adjust a network parameter of the second adjustment model based on the first type of the data included in the first data set to obtain a third adjustment model.

In the operation 14, the network parameter of the second adjustment model is adjusted in an adversarial training manner based on the first type of the data included in the first data set to obtain the third adjustment model.

15: Determine whether the third adjustment model meets a first condition; and if the third adjustment model does not meet a first condition, go to perform an operation 16, or if the third adjustment model meets a first condition, perform an operation 17.

In some embodiments, the first condition may be that a quantity of times of training the third adjustment model reaches a specified quantity of times. To be specific, an initial value of the quantity of times of training the third adjustment model may be initialized first, and the quantity of times of training the third adjustment model is increased each time the operation 11 is returned to be performed.

In some embodiments, the first condition may be that the third adjustment model converges. For example, a loss function value of the third adjustment model remains unchanged, or a gradient value of the third adjustment model remains unchanged.

16: Use the second discriminator network as the first discriminator network, use the third adjustment model as the second adjustment model, and return to perform the operation 11.

17: Determine the third adjustment model as the first adjustment model, and end the operation.

3042: Adjust the visual characteristics of the plurality of pieces of first simulation data based on the first adjustment model to obtain the plurality of pieces of second simulation data.

The plurality of pieces of first simulation data are in a one-to-one correspondence with the plurality of pieces of second simulation data.

In 3042, the plurality of pieces of first simulation data are input into the first adjustment model, so that the first adjustment model adjusts the visual characteristics of the plurality of pieces of first simulation data to obtain the plurality of pieces of second simulation data. In this way, the plurality of pieces of second simulation data output by the first adjustment model are obtained.

In some embodiments, for any piece of first simulation data, the first adjustment model adjusts a visual characteristic of the piece of first simulation data to obtain one piece of second simulation data. To be specific, the first adjustment model adjusts the visual characteristic such as texture, illumination, or an object image shape of the piece of first simulation data to obtain the piece of second simulation data.

Step 305: Adjust the second AI model based on the at least one piece of second data and the plurality of pieces of second simulation data to obtain the first AI model.

In step 305, the second AI model may be adjusted by performing the following procedures 3051 and 3052 to obtain the first AI model.

3051: Adjust a network parameter of the second AI model based on the at least one piece of second data and the plurality of pieces of second simulation data to obtain a third AI model, where features that are of the plurality of pieces of second simulation data and that are extracted based on the third AI model are closer to a feature of the at least one piece of second data than features that are of the plurality of pieces of second simulation data and that are extracted based on the second AI model.

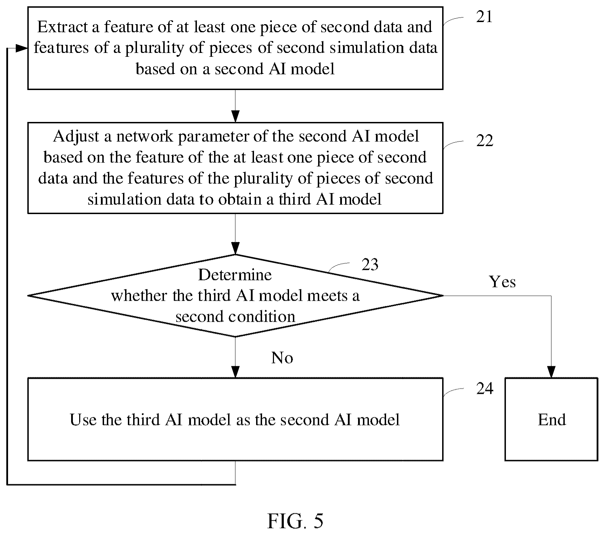

In some embodiments, with reference to FIG. 5, the network parameter of the second AI model is adjusted by performing the following procedures to obtain the third AI model.

21: Extract the feature of the at least one piece of second data and the features of the plurality of pieces of second simulation data based on the second AI model.

In the operation 21, the at least one piece of second data and the plurality of pieces of second simulation data are input into the second AI model, so that the second AI model extracts the feature of the at least one piece of second data and the features of the plurality of pieces of second simulation data. In this way, the feature of the at least one piece of second data and the features of the plurality of pieces of second simulation data that are output by the second AI model are obtained.

22: Adjust the network parameter of the second AI model based on the feature of the at least one piece of second data and the features of the plurality of pieces of second simulation data to obtain the third AI model.

In the operation 22, the network parameter of the second AI model may be adjusted in the following two manners to obtain the third AI model.

In a first manner: Calculate a distance between the feature of the at least one piece of second data and the features of the plurality of pieces of second simulation data, and adjust the network parameter of the second AI model based on the calculated distance to obtain the third AI model.

In a process of adjusting the network parameter of the second AI model, the network parameter of the second AI model is adjusted toward a direction of reducing the distance between the feature of the at least one piece of second data and the features of the plurality of pieces of second simulation data to obtain the third AI model.

In a second manner: Determine a first type of data in a second data set by using the second discriminator network based on the feature of the at least one piece of second data and the features of the plurality of pieces of second simulation data, where the second data set includes the at least one piece of second data and the plurality of pieces of second simulation data; and adjust the network parameter of the second AI model in an adversarial training manner based on the second type of the at least one piece of second data and the first type of the data in the second data set to obtain the third AI model.

In the second manner, the feature of the at least one piece of second data and the features of the plurality of pieces of second simulation data are input into the second discriminator network, so that the second discriminator network determines a first type of each piece of data in the second data set based on the feature of the at least one piece of second data and the features of the plurality of pieces of second simulation data. In this way, the first type that is of each piece of data in the second data set and that is output by the second discriminator network is obtained. The network parameter of the second AI model is adjusted in the adversarial training manner based on the second type of the at least one piece of second data and the first type of the data in the second data set to obtain the third AI model.

23: Determine whether the third AI model meets a second condition; and if the third AI model does not meet a second condition, perform an operation 24, or if the third AI model meets a second condition, end the operation.

In some embodiments, the second condition may be that a quantity of times of training the third AI model reaches a specified quantity of times. To be specific, an initial value of the quantity of times of training the third AI model may be initialized first, and the quantity of times of training the third AI model is increased each time the operation 21 is returned to be performed.

In some embodiments, the second condition may be that the third AI model converges. For example, a loss function value of the third AI model remains unchanged, or a gradient value of the third adjustment model remains unchanged.

24: Use the third AI model as the second AI model, and return to perform the operation 21.

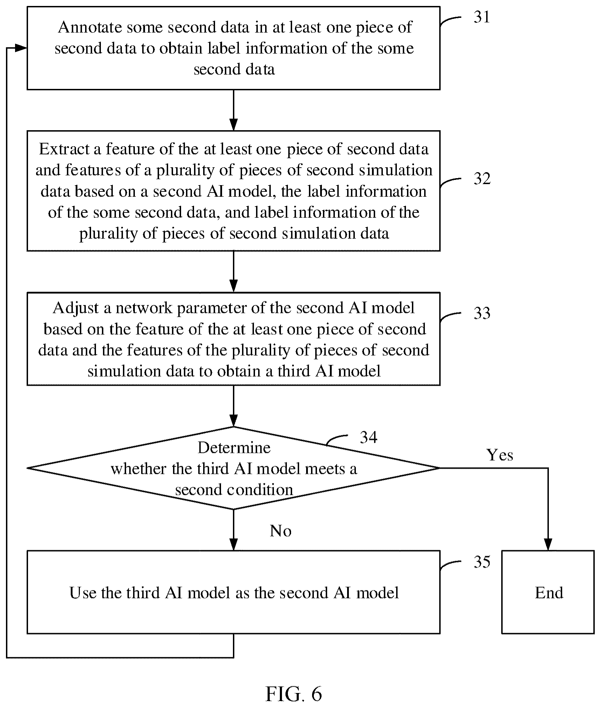

In some embodiments, with reference to FIG. 6, the network parameter of the second AI model is adjusted by performing the following procedures to obtain the third AI model.

31: Annotate some second data in the at least one piece of second data to obtain label information of the some second data.

In the operation 31, the at least one piece of second data is annotated based on the multi-modal model to obtain label information of the at least one piece of second data. To be specific, for any piece of second data, the second data is input into the multi-modal model, so that the multi-modal model annotates the second data to obtain label information of the first data. In this way, the label information that is of the second data that is output by the multi-modal model is obtained.

32: Extract the feature of the at least one piece of second data and the features of the plurality of pieces of second simulation data based on the second AI model, the label information of the some second data, and the label information of the plurality of pieces of second simulation data.

In the operation 32, the label information of the some second data, the label information of the plurality of pieces of second simulation data, the at least one piece of second data, and the plurality of pieces of second simulation data are input into the second AI model, so that the second AI model extracts the feature of the at least one piece of second data and the features of the plurality of pieces of second simulation data based on the label information of the some second data and the label information of the plurality of pieces of second simulation data. In this way, the feature of the at least one piece of second data and the features of the plurality of pieces of second simulation data that are output by the second AI model are obtained.

33: Adjust the network parameter of the second AI model based on the feature of the at least one piece of second data and the features of the plurality of pieces of second simulation data to obtain the third AI model.

In the operation 33, the network parameter of the second AI model may be adjusted in the first manner or the second manner to obtain the third AI model. Details are not described herein again.

34: Determine whether the third AI model meets a second condition; and if the third AI model does not meet a second condition, perform an operation 35, or if the third AI model meets a second condition, end the operation.

35: Use the third AI model as the second AI model, and return to perform the operation 31.

3052: Adjust a network parameter of the third AI model based on a second data set and label information of data in the second data set to obtain the first AI model, where the second data set includes the at least one piece of second data and the plurality of pieces of second simulation data.

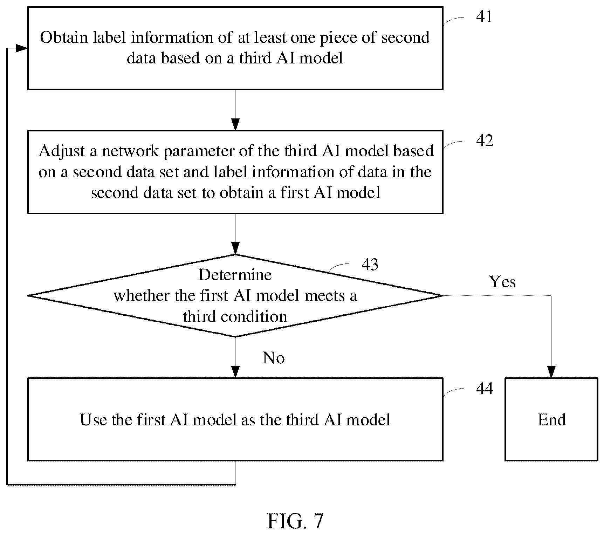

In some embodiments, with reference to FIG. 7, the network parameter of the third AI model may be adjusted by performing the following procedures to obtain the first AI model.

41: Obtain the label information of the at least one piece of second data based on the third AI model.

In the operation 41, the at least one piece of second data is input into the third AI model, so that the third AI model performs inference on the at least one piece of second data to obtain the label information of the at least one piece of second data. In this way, the label information that is of the at least one piece of second data and that is output by the third AI model is obtained.

42: Adjust the network parameter of the third AI model based on the second data set and the label information of the data in the second data set to obtain the first AI model.

The label information of the data in the second data set includes the label information that is of the at least one piece of second data and that is output by the third AI model, and the label information of the plurality of pieces of second simulation data.

For each of the plurality of pieces of second simulation data, label information of the second simulation data is the same as label information of first simulation data corresponding to the second simulation data. Alternatively, the plurality of pieces of second simulation data are annotated based on the multi-modal model to obtain the label information of the plurality of pieces of second simulation data.

In the operation 42, for any piece of data (which may be second data or may be second simulation data) in the second data set, the data and label information corresponding to the data constitute a third training sample, and a plurality of third training samples may be obtained by repeating the foregoing process. Model training is performed on the third AI model by using the plurality of third training samples to obtain the first AI model.

43: Determine whether the first AI model meets a third condition; and if the first AI model does not meet a third condition, perform an operation 44, or if the first AI model meets a third condition, end the operation.

In some embodiments, the third condition may be that a quantity of times of training the first AI model reaches a specified quantity of times. To be specific, an initial value of the quantity of times of training the first AI model may be initialized first, and the quantity of times of training the first AI model is increased each time the operation 41 is returned to be performed.

In some embodiments, the third condition may be that the first AI model converges. For example, a loss function value of the first AI model remains unchanged, or a gradient value of the first adjustment model remains unchanged.

44: Use the first AI model as the third AI model, and return to perform the operation 41.

In some embodiments, at least one simulation platform may be generated in the simulation environment, the first AI model is deployed on the at least one simulation platform, and the at least one simulation platform is used to test the first AI model. Then, running effect and performance of the first AI model are observed.

For example, it is assumed that the first AI model needs to be deployed on a vehicle or a robot, and whether an accident such as a collision occurs on the self-driving vehicle or the robot may be observed on the simulation platform. Determine, based on a test result, whether to continue training the first AI model. If training continues, return to perform step 304.

In some embodiments, the first AI model may be deployed on at least one terminal device in the real environment. For each of the at least one terminal device, the terminal device collects data in the real environment to obtain at least one piece of real data, and performs inference on the at least one piece of real data to obtain label information of the at least one piece of real data.

In some embodiments, the terminal device adjusts, based on the at least one piece of real data and the label information of the at least one piece of real data, the first AI model deployed on the terminal device.

In some embodiments, the terminal device sends the at least one piece of real data and the label information of the at least one piece of real data to the cloud service platform.

In this way, the at least one piece of real data and the label information of the at least one piece of real data that are sent by the terminal device are received. The first AI model is adjusted based on the at least one piece of real data and the label information of the at least one piece of real data. In this way, after the first AI model is deployed on the terminal device, the first AI model may be continuously optimized, so that accuracy of the first AI model becomes increasingly high.

In some embodiments, the operation of adjusting the first AI model may be as follows: The at least one piece of real data and the label information of the at least one piece of real data constitute at least one fourth training sample, where each of the at least one fourth training sample includes one piece of real data and label information of the piece of real data; and the first AI model is trained based on the at least one constituted fourth training sample.

In this embodiment of this application, the plurality of pieces of real data sent by the data collection device are received, and the plurality of pieces of real data include the at least one piece of first data and the at least one piece of second data. The simulation environment is created based on the at least one piece of first data. Because the simulation environment is created based on real data, accuracy of the created simulation environment can be improved. In addition, the plurality of pieces of real data include the image data, the radar data, the object point cloud data, or the object IMU data. The plurality of pieces of real data may be data in 3D space, and may be applied to a real environment of the 3D space.

The plurality of pieces of first simulation data are obtained based on the simulation environment. Model training is performed based on the at least one piece of first data and the plurality of pieces of first simulation data to obtain the second AI model. The plurality of pieces of first simulation data are adjusted based on the at least one piece of second data to obtain the plurality of pieces of second simulation data, so that the plurality of pieces of second simulation data are closer to the data describing the real environment. The second AI model is adjusted based on the at least one piece of second data and the plurality of pieces of second simulation data to obtain the first AI model, so that the first AI model with high accuracy can be obtained, and accuracy of model training can be improved.

Then, the first AI model is deployed on the at least one terminal device in the real environment, and the terminal device collects the data in the real environment to obtain the at least one piece of real data, and performs inference on the at least one piece of real data to obtain the label information of the at least one piece of real data. The at least one piece of real data and the label information of the at least one piece of real data that are sent by the terminal device are received. The first AI model is adjusted based on the at least one piece of real data and the label information of the at least one piece of real data, so that the first AI model can be continuously optimized after the first AI model is deployed.

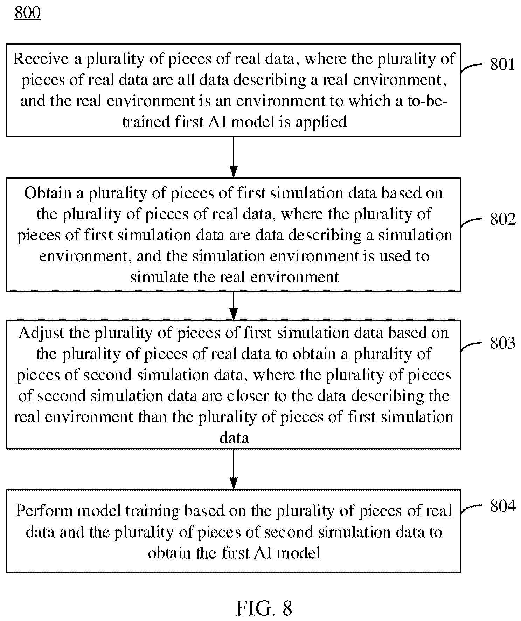

With reference to FIG. 8, an embodiment of this application provides a model training method 800. The method 800 is applied to the network architecture 100 shown in FIG. 1 or FIG. 2. The method 800 includes the following steps.

Step 801: Receive a plurality of pieces of real data, where the plurality of pieces of real data are all data describing a real environment, and the real environment is an environment to which a to-be-trained first AI model is applied.

In step 801, for a detailed implementation process of receiving the plurality of pieces of real data, refer to the related content of step 301 in the method 300 shown in FIG. 3. Details are not described herein again.

Step 802: Obtain a plurality of pieces of first simulation data based on the plurality of pieces of real data, where the plurality of pieces of first simulation data are data describing a simulation environment, and the simulation environment is used to simulate the real environment.

In step 802, for a detailed implementation process of obtaining the plurality of pieces of first simulation data based on the plurality of pieces of real data, refer to the related content "Obtain a plurality of pieces of first simulation data based on at least one piece of first data" in step 302 of the method 300 shown in FIG. 3. Details are not described herein again.

Step 803: Adjust the plurality of pieces of first simulation data based on the plurality of pieces of real data to obtain a plurality of pieces of second simulation data, where the plurality of pieces of second simulation data are closer to the data of the real environment than the plurality of pieces of first simulation data.

In step 803, for a detailed implementation process of adjusting the plurality of pieces of first simulation data based on the plurality of pieces of real data to obtain the plurality of pieces of second simulation data, refer to the related content "Adjust the plurality of pieces of first simulation data based on at least one piece of second data to obtain a plurality of pieces of second simulation data" in step 304 of the method 300 shown in FIG. 3. Details are not described herein again.

Step 804: Perform model training based on the plurality of pieces of real data and the plurality of pieces of second simulation data to obtain the first AI model.

In step 803, the plurality of pieces of second simulation data are annotated based on a multi-modal model to obtain label information of the plurality of pieces of second simulation data. The plurality of pieces of second simulation data and the label information of the plurality of pieces of second simulation data constitute a plurality of training samples. Each of the plurality of training samples includes one piece of second simulation data and label information of the piece of second simulation data.

The plurality of pieces of real data are annotated based on the multi-modal model to obtain label information of the plurality of pieces of real data. The plurality of pieces of real data and the label information of the plurality of pieces of real data constitute a plurality of training samples. Each of the plurality of training samples includes one piece of real data and label information of the piece of real data.

Model training is performed based on each constituted training sample to obtain the first AI model.

In some embodiments, model training is performed on a blank model based on each constituted training sample to obtain the first AI model.

In some embodiments, a received training task indicates a function, and an AI model with the function is obtained. An environment to which the AI model is applied is different from the real environment. Model training is performed, based on each constituted training sample, on the obtained AI model to obtain the first AI model.

In this embodiment of this application, the plurality of pieces of real data sent by a data collection device are received, and the simulation environment is created based on the plurality of pieces of real data. Because the simulation environment is created based on the real data, accuracy of the created simulation environment can be improved. The plurality of pieces of first simulation data are obtained based on the simulation environment. The plurality of pieces of first simulation data are adjusted based on the plurality of pieces of real data to obtain the plurality of pieces of second simulation data, so that the plurality of pieces of second simulation data are closer to the data describing the real environment. Model training is performed based on the plurality of pieces of real data and the plurality of pieces of second simulation data to obtain the first AI model, so that the first AI model with high accuracy can be obtained, and accuracy of model training can be improved.

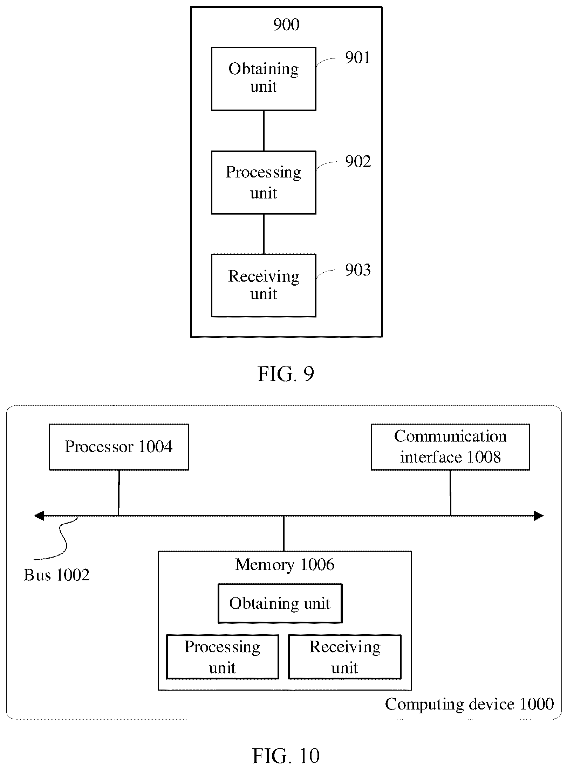

With reference to FIG. 9, an embodiment of this application provides a model training apparatus 900. The apparatus 900 is used in a cloud service platform. The cloud service platform may be the cloud service platform 101 in the network architecture 100 shown in FIG. 1 or FIG. 2, or the cloud service platform in the method 300 shown in FIG. 3, or the cloud service platform in the method 800 shown in FIG. 8. The apparatus 900 includes:
an obtaining unit 901, configured to obtain a plurality of pieces of real data and a plurality of pieces of first simulation data, where the plurality of pieces of real data are data describing a real environment, the real environment is an environment to which a to-be-trained first artificial intelligence AI model is applied, the plurality of pieces of first simulation data are data describing a simulation environment, and the simulation environment is used to simulate the real environment; and
a processing unit 902, configured to adjust the plurality of pieces of first simulation data based on the plurality of pieces of real data to obtain a plurality of pieces of second simulation data.

The processing unit 902 is further configured to perform model training based on the plurality of pieces of real data and the plurality of pieces of second simulation data to obtain the first AI model.

Optionally, the plurality of pieces of second simulation data are closer to the data describing the real environment than the plurality of pieces of first simulation data.

Optionally, for a detailed implementation process in which the obtaining unit 901 obtains the plurality of pieces of real data and the plurality of pieces of first simulation data, refer to the related content in steps 301 and 302 of the method 300 shown in FIG. 3 and steps 801 and 802 of the method 800 shown in FIG. 8. Details are not described herein again.

Optionally, for a detailed implementation process in which the processing unit 902 adjusts the plurality of pieces of first simulation data to obtain the plurality of pieces of second simulation data, refer to the related content in step 304 of the method 300 shown in FIG. 3 and step 803 of the method 800 shown in FIG. 8. Details are not described herein again.

Optionally, for a detailed implementation process in which the processing unit 902 performs model training based on the plurality of pieces of real data and the plurality of pieces of second simulation data to obtain the first AI model, refer to the related content in step 305 of the method 300 shown in FIG. 3 and step 804 of the method 800 shown in FIG. 8. Details are not described herein again.

Optionally, the plurality of pieces of real data include at least one piece of first data and at least one piece of second data; and the processing unit 902 is configured to:
adjust the plurality of pieces of first simulation data based on the at least one piece of second data to obtain the plurality of pieces of second simulation data;
perform model training based on the at least one piece of first data and the plurality of pieces of first simulation data to obtain a second AI model; and
adjust the second AI model based on the at least one piece of second data and the plurality of pieces of second simulation data to obtain the first AI model.

Optionally, for a detailed implementation process in which the processing unit 902 adjusts the plurality of pieces of first simulation data based on the at least one piece of second data to obtain the plurality of pieces of second simulation data, refer to the related content in step 304 of the method 300 shown in FIG. 3. Details are not described herein again.

Optionally, for a detailed implementation process in which the processing unit 902 performs model training based on the at least one piece of first data and the plurality of pieces of first simulation data to obtain the second AI model, refer to the related content in step 303 of the method 300 shown in FIG. 3. Details are not described herein again.

Optionally, for a detailed implementation process in which the processing unit 902 adjusts the second AI model based on the at least one piece of second data and the plurality of pieces of second simulation data to obtain the first AI model, refer to the related content in step 305 of the method 300 shown in FIG. 3. Details are not described herein again.

Optionally, the obtaining unit 901 is configured to:
create the simulation environment based on the at least one piece of first data; and
generate the plurality of pieces of first simulation data based on the simulation environment.

Optionally, for a detailed implementation process in which the obtaining unit 901 creates the simulation environment based on the at least one piece of first data, refer to the related content in step 3021 of the method 300 shown in FIG. 3. Details are not described herein again.

Optionally, for a detailed implementation process in which the obtaining unit 901 generates the plurality of pieces of first simulation data based on the simulation environment, refer to the related content in step 3022 of the method 300 shown in FIG. 3. Details are not described herein again.

Optionally, the processing unit 902 is configured to:
obtain a first adjustment model based on the at least one piece of second data and the plurality of pieces of first simulation data, where the first adjustment model is used to adjust a visual characteristic of simulation data toward a visual characteristic of the data describing the real environment; and
adjust visual characteristics of the plurality of pieces of first simulation data based on the first adjustment model to obtain the plurality of pieces of second simulation data.

Optionally, for a detailed implementation process in which the processing unit 902 obtains the first adjustment model based on the at least one piece of second data and the plurality of pieces of first simulation data, refer to the related content in step 3041 of the method 300 shown in FIG. 3. Details are not described herein again.

Optionally, for a detailed implementation process in which the processing unit 902 adjusts the visual characteristics of the plurality of pieces of first simulation data based on the first adjustment model to obtain the plurality of pieces of second simulation data, refer to the related content in step 3042 of the method 300 shown in FIG. 3. Details are not described herein again.

Optionally, the processing unit 902 is configured to:
adjust the visual characteristics of the plurality of pieces of first simulation data based on a second adjustment model to obtain a plurality of pieces of third simulation data;
determine, based on a first discriminator network, a first type of data included in a first data set, where the first type indicates whether the data is real data or simulation data, and the first data set includes the at least one piece of second data and the plurality of pieces of third simulation data;
adjust a network parameter of the second adjustment model based on the first type of the data included in the first data set to obtain a third adjustment model; and
when the third adjustment model meets a first condition, determine the third adjustment model as the first adjustment model.

Optionally, the processing unit 902 is further configured to:
when the third adjustment model does not meet the first condition, adjust a network parameter of the first discriminator network based on a second type of the at least one piece of second data and the first type of the data included in the first data set to obtain a second discriminator network, where the second type indicates that the at least one piece of second data is real data;
adjust the visual characteristics of the plurality of pieces of first simulation data based on the third adjustment model to obtain a plurality of pieces of fourth simulation data;
determine, based on the second discriminator network, a first type of data included in a second data set, where the second data set includes the at least one piece of second data and the plurality of pieces of fourth simulation data;
adjust a network parameter of the third adjustment model based on the first type of the data included in the second data set to obtain a fourth adjustment model; and
when the fourth adjustment model meets the first condition, determine the fourth adjustment model as the first adjustment model.

Optionally, the processing unit 902 is configured to:
adjust a network parameter of the second AI model based on the at least one piece of second data and the plurality of pieces of second simulation data to obtain a third AI model, where features that are of the plurality of pieces of second simulation data and that are extracted based on the third AI model are closer to a feature of the at least one piece of second data than features that are of the plurality of pieces of second simulation data and that are extracted based on the second AI model; and
adjust a network parameter of the third AI model based on a third data set and label information of data in the third data set to obtain the first AI model, where the third data set includes the at least one piece of second data and the plurality of pieces of second simulation data.

Optionally, for a detailed implementation process in which the processing unit 902 adjusts the network parameter of the second AI model based on the at least one piece of second data and the plurality of pieces of second simulation data to obtain the third AI model, refer to the related content in step 3051 of the method 300 shown in FIG. 3. Details are not described herein again.

Optionally, for a detailed implementation process in which the processing unit 902 adjusts the network parameter of the third AI model based on the third data set and the label information of the data in the third data set to obtain the first AI model, refer to the related content in step 3052 of the method 300 shown in FIG. 3. Details are not described herein again.

Optionally, the processing unit 902 is configured to:
extract the feature of the at least one piece of second data and the features of the plurality of pieces of second simulation data based on the second AI model; and
adjust the network parameter of the second AI model based on the feature of the at least one piece of second data and the features of the plurality of pieces of second simulation data to obtain the third AI model.

Optionally, the processing unit 902 is configured to:
annotate the plurality of pieces of second simulation data to obtain label information of the plurality of pieces of second simulation data;
annotate some second data in the at least one piece of second data to obtain label information of the some second data; and
extract the feature of the at least one piece of second data and the features of the plurality of pieces of second simulation data based on the second AI model, the label information of the some second data, and the label information of the plurality of pieces of second simulation data.

Optionally, the label information of the data in the third data set includes label information of the at least one piece of second data and label information of the plurality of pieces of second simulation data.

The processing unit 902 is further configured to:
perform inference on the at least one piece of second data based on the third AI model to obtain the label information of the at least one piece of second data; and
annotate the plurality of pieces of second simulation data based on a multi-modal model to obtain the label information of the plurality of pieces of second simulation data.

Optionally, the apparatus 900 further includes a receiving unit 903.

The receiving unit 903 is configured to receive at least one piece of real data and label information of the at least one piece of real data that are sent by a terminal device. The terminal device is located in the real environment, the at least one piece of real data is data collected by the terminal device in the real environment, and the label information of the at least one piece of real data is obtained by the terminal device by performing inference on the at least one piece of truth data based on the first AI model.

The processing unit 902 is further configured to adjust the first AI model based on the at least one piece of real data and the label information of the at least one piece of real data.

Optionally, for a detailed implementation process in which the receiving unit 903 receives the at least one piece of real data and the label information of the at least one piece of real data, refer to the related content in step 305 of the method 300 shown in FIG. 3. Details are not described herein again.

Optionally, for a detailed implementation process in which the processing unit 902 adjusts the first AI model based on the at least one piece of real data and the label information of the at least one piece of real data, refer to the related content in step 305 of the method 300 shown in FIG. 3. Details are not described herein again.

Optionally, the plurality of pieces of real data include one or more of the following data: image data, radar data, object point cloud data, or object inertial measurement unit IMU data.

In this embodiment of this application, because the processing unit adjusts the plurality of pieces of first simulation data based on the plurality of pieces of real data to obtain the plurality of pieces of second simulation data, the plurality of pieces of second simulation data are closer to the data describing the real environment than the plurality of pieces of first simulation data. In this way, the processing unit performs model training based on the plurality of pieces of real data and the plurality of pieces of second simulation data to obtain the first AI model, so that accuracy of the first AI model obtained through training can be improved.

With reference to FIG. 10, an embodiment of this application provides a computing device 1000. For example, the computing device 1000 may be a device in the cloud service platform in the network architecture shown in FIG. 1 or FIG. 2, or a device in the cloud service platform in the method 300 shown in FIG. 3 or the method 800 shown in FIG. 8.

As shown in FIG. 10, the computing device 1000 includes a bus 1002, a processor 1004, a memory 1006, and a communication interface 1008. The processor 1004, the memory 1006, and the communication interface 1008 communicate with each other through the bus 1002. The computing device 1000 may be a server or a terminal device. It should be understood that quantities of processors and memories in the computing device 1000 are not limited in this application.

The bus 1002 may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, the bus is represented by using only one line in FIG. 10. However, it does not mean that there is only one bus or only one type of bus. The bus 1004 may include a path for information transmission between components (for example, the processor 1004, the memory 1006, and the communication interface 1008) of the computing device 1000.

The processor 1004 may include any one or more of processors such as a central processing unit (central processing unit, CPU), a graphics processing unit (graphics processing unit, GPU), a microprocessor (microprocessor, MP), or a digital signal processor (digital signal processor, DSP).

The memory 1006 may include a volatile memory (volatile memory), for example, a random access memory (random access memory, RAM). The memory 1006 may further include a non-volatile memory (non-volatile memory), for example, a read-only memory (read-only memory, ROM), a flash memory, a hard disk drive (hard disk drive, HDD), or a solid-state drive (solid-state drive, SSD).

With reference to FIG. 10, the memory 1006 stores executable program code, and the processor 1004 executes the executable program code to separately implement functions of the obtaining unit 901, the processing unit 902, and the receiving unit 903 in the apparatus 900 shown in FIG. 9, to implement the method provided in any one of the foregoing embodiments. In other words, the memory 1006 stores instructions used to perform the method provided in any one of the foregoing embodiments.

The communication interface 1008 uses a transceiver module, for example, but not limited to, a network interface card or a transceiver, to implement communication between the computing device 1000 and another device or a communication network.

An embodiment of this application further provides a computing device cluster. The computing device cluster includes at least one computing device. The computing device may be a server, for example, a central server, an edge server, or a local server in a local data center. In some embodiments, the computing device may alternatively be a terminal device, for example, a desktop computer, a notebook computer, or a smartphone.

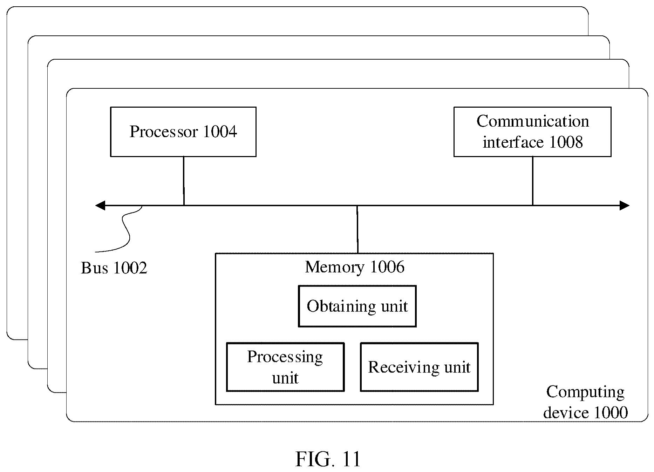

As shown in FIG. 11, the computing device cluster includes at least one computing device 1000. A memory 1006 in one or more computing devices 1000 in the computing device cluster may store same instructions used to perform the method provided in any one of the foregoing embodiments.

In some possible implementations, the memory 1006 in the one or more computing devices 1000 in the computing device cluster may alternatively separately store some instructions used to perform the foregoing data management method. In other words, a combination of the one or more computing devices 1000 may jointly execute instructions used to perform the method provided in any one of the foregoing embodiments.

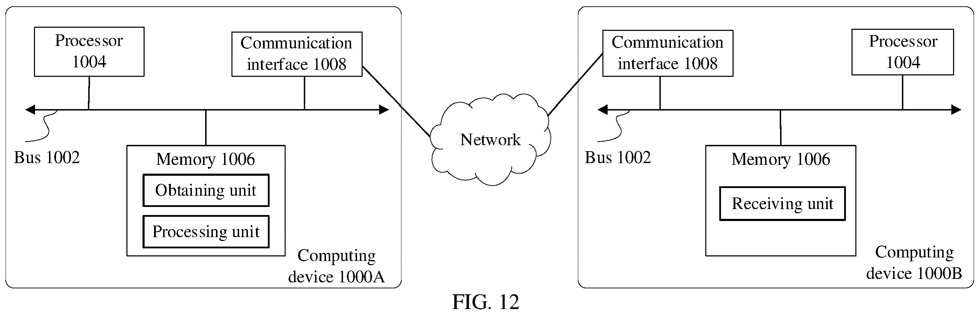

In some possible implementations, the one or more computing devices in the computing device cluster may be connected through a network. The network may be a wide area network, a local area network, or the like. FIG. 12 shows a possible implementation. As shown in FIG. 12, two computing devices 1000A and 1000B are connected through a network. Specifically, each computing device is connected to the network through a communication interface in each computing device.

In this possible implementation, a memory 1006 in the computing device 1000A stores instructions for executing functions of the obtaining unit 901 and the processing unit 902 in the embodiment shown in FIG. 9. In addition, a memory 1006 in the computing device 1000B stores instructions for executing a function of the receiving unit 903 in the embodiment shown in FIG. 9.

It should be understood that a function of the computing device 1000A shown in FIG. 12 may alternatively be completed by a plurality of computing devices 1000. Similarly, a function of the computing device 1000B may alternatively be completed by a plurality of computing devices 1000.

An embodiment of this application further provides another computing device cluster. For a connection relationship between computing devices in the computing device cluster, refer to the connection manner of the computing device cluster in FIG. 12. A difference lies in that a memory 1006 in one or more computing devices 1000 in the computing device cluster may store same instructions used to perform the method provided in any one of the foregoing embodiments.

In some possible implementations, the memory 1006 in the one or more computing devices 1000 in the computing device cluster may alternatively separately store some instructions used to perform the method provided in any one of the foregoing embodiments. In other words, a combination of the one or more computing devices 1000 may jointly execute instructions used to perform the method provided in any one of the foregoing embodiments.

An embodiment of this application further provides a computer program product including instructions. The computer program product may be software or a program product that includes the instructions and that can run on a computing device or be stored in any usable medium. When the computer program product runs on at least one computing device, the at least one computing device is enabled to perform the method provided in any one of the foregoing embodiments.

An embodiment of this application further provides a computer-readable storage medium. The computer-readable storage medium may be any usable medium that can be stored by a computing device, or a data storage device, such as a data center, including one or more usable media. The usable medium may be a magnetic medium (for example, a floppy disk, a hard disk drive, or a magnetic tape), an optical medium (for example, a DVD), a semiconductor medium (for example, a solid-state drive), or the like. The computer-readable storage medium includes instructions, and the instructions instruct the computing device to perform the method provided in any one of the foregoing embodiments.

A person of ordinary skill in the art may understand that all or some of the steps of the embodiments may be implemented by hardware or a program instructing related hardware. The program may be stored in a computer-readable storage medium. The storage medium may be a read-only memory, a magnetic disk, an optical disc, or the like.

The foregoing descriptions are merely optional embodiments of this application, but are not intended to limit this application. Any modification, equivalent replacement, improvement, or the like made within the principle of this application should fall within the protection scope of this application.

## Claims

1. A model training method, wherein the method is applied to a cloud service platform and comprises:
obtaining a plurality of pieces of real data and a plurality of pieces of first simulation data, wherein the plurality of pieces of real data are data describing a real environment, the real environment is an environment to which a to-be-trained first artificial intelligence AI model is applied, the plurality of pieces of first simulation data are data describing a simulation environment, and the simulation environment is used to simulate the real environment;
adjusting the plurality of pieces of first simulation data based on the plurality of pieces of real data to obtain a plurality of pieces of second simulation data; and
performing model training based on the plurality of pieces of real data and the plurality of pieces of second simulation data to obtain the first AI model.

2. The method according to claim 1, wherein the plurality of pieces of real data comprise at least one piece of first data and at least one piece of second data;
adjusting the plurality of pieces of first simulation data based on the plurality of pieces of real data to obtain the plurality of pieces of second simulation data comprises:
adjusting the plurality of pieces of first simulation data based on the at least one piece of second data to obtain the plurality of pieces of second simulation data; and
performing model training based on the plurality of pieces of real data and the plurality of pieces of second simulation data to obtain the first AI model comprises:
performing model training based on the at least one piece of first data and the plurality of pieces of first simulation data to obtain a second AI model; and
adjusting the second AI model based on the at least one piece of second data and the plurality of pieces of second simulation data to obtain the first AI model.

3. The method according to claim 2, wherein obtaining the plurality of pieces of first simulation data comprises:
creating the simulation environment based on the at least one piece of first data; and
generating the plurality of pieces of first simulation data based on the simulation environment.

4. The method according to claim 2 or 3, wherein adjusting the plurality of pieces of first simulation data based on the at least one piece of second data to obtain the plurality of pieces of second simulation data comprises:
obtaining a first adjustment model based on the at least one piece of second data and the plurality of pieces of first simulation data, wherein the first adjustment model is used to adjust a visual characteristic of simulation data toward a visual characteristic of the data describing the real environment; and
adjusting visual characteristics of the plurality of pieces of first simulation data based on the first adjustment model to obtain the plurality of pieces of second simulation data.

5. The method according to claim 4, wherein obtaining the first adjustment model based on the at least one piece of second data and the plurality of pieces of first simulation data comprises:
adjusting the visual characteristics of the plurality of pieces of first simulation data based on a second adjustment model to obtain a plurality of pieces of third simulation data;
determining, based on a first discriminator network, a first type of data comprised in a first data set, wherein the first type indicates whether the data is real data or simulation data, and the first data set comprises the at least one piece of second data and the plurality of pieces of third simulation data;
adjusting a network parameter of the second adjustment model based on the first type of the data comprised in the first data set to obtain a third adjustment model; and
when the third adjustment model meets a first condition, determining the third adjustment model as the first adjustment model.

6. The method according to claim 5, wherein obtaining the first adjustment model based on the at least one piece of second data and the plurality of pieces of first simulation data further comprises:
when the third adjustment model does not meet the first condition, adjusting a network parameter of the first discriminator network based on a second type of the at least one piece of second data and the first type of the data comprised in the first data set to obtain a second discriminator network, wherein the second type indicates that the at least one piece of second data is real data;
adjusting the visual characteristics of the plurality of pieces of first simulation data based on the third adjustment model to obtain a plurality of pieces of fourth simulation data;
determining, based on the second discriminator network, a first type of data comprised in a second data set, wherein the second data set comprises the at least one piece of second data and the plurality of pieces of fourth simulation data;
adjusting a network parameter of the third adjustment model based on the first type of the data comprised in the second data set to obtain a fourth adjustment model; and
when the fourth adjustment model meets the first condition, determining the fourth adjustment model as the first adjustment model.

7. The method according to any one of claims 2 to 6, wherein adjusting the second AI model based on the at least one piece of second data and the plurality of pieces of second simulation data to obtain the first AI model comprises:
adjusting a network parameter of the second AI model based on the at least one piece of second data and the plurality of pieces of second simulation data to obtain a third AI model, wherein features that are of the plurality of pieces of second simulation data and that are extracted based on the third AI model are closer to a feature of the at least one piece of second data than features that are of the plurality of pieces of second simulation data and that are extracted based on the second AI model; and
adjusting a network parameter of the third AI model based on a third data set and label information of data in the third data set to obtain the first AI model, wherein the third data set comprises the at least one piece of second data and the plurality of pieces of second simulation data.

8. The method according to claim 7, wherein adjusting the network parameter of the second AI model based on the at least one piece of second data and the plurality of pieces of second simulation data to obtain the third AI model comprises:
extracting the feature of the at least one piece of second data and the features of the plurality of pieces of second simulation data based on the second AI model; and
adjusting the network parameter of the second AI model based on the feature of the at least one piece of second data and the features of the plurality of pieces of second simulation data to obtain the third AI model.

9. The method according to claim 8, wherein the method further comprises:
annotating the plurality of pieces of second simulation data to obtain label information of the plurality of pieces of second simulation data;
annotating some second data in the at least one piece of second data to obtain label information of the some second data; and
extracting the feature of the at least one piece of second data and the features of the plurality of pieces of second simulation data based on the second AI model comprises:
extracting the feature of the at least one piece of second data and the features of the plurality of pieces of second simulation data based on the second AI model, the label information of the some second data, and the label information of the plurality of pieces of second simulation data.

10. The method according to claim 7 or 8, wherein the label information of the data in the third data set comprises label information of the at least one piece of second data and label information of the plurality of pieces of second simulation data; and
before adjusting the network parameter of the third AI model based on the third data set and the label information of the data in the third data set to obtain the first AI model, the method further comprises:
performing inference on the at least one piece of second data based on the third AI model to obtain the label information of the at least one piece of second data; and
annotating the plurality of pieces of second simulation data based on a multi-modal model to obtain the label information of the plurality of pieces of second simulation data.

11. The method according to any one of claims 1 to 10, wherein the method further comprises:
receiving at least one piece of real data and label information of the at least one piece of real data that are sent by a terminal device, wherein the terminal device is located in the real environment, the at least one piece of real data is data collected by the terminal device in the real environment, and the label information of the at least one piece of real data is obtained by the terminal device by performing inference on the at least one piece of truth data based on the first AI model; and
adjusting the first AI model based on the at least one piece of real data and the label information of the at least one piece of real data.

12. The method according to any one of claims 1 to 11, wherein the plurality of pieces of real data comprise one or more of the following data: image data, radar data, object point cloud data, or object inertial measurement unit IMU data.

13. A model training apparatus, wherein the apparatus is deployed on a cloud service platform and comprises:
an obtaining unit, configured to obtain a plurality of pieces of real data and a plurality of pieces of first simulation data, wherein the plurality of pieces of real data are data describing a real environment, the real environment is an environment to which a to-be-trained first artificial intelligence AI model is applied, the plurality of pieces of first simulation data are data describing a simulation environment, and the simulation environment is used to simulate the real environment; and
a processing unit, configured to adjust the plurality of pieces of first simulation data based on the plurality of pieces of real data to obtain a plurality of pieces of second simulation data, wherein
the processing unit is further configured to perform model training based on the plurality of pieces of real data and the plurality of pieces of second simulation data to obtain the first AI model.

14. The apparatus according to claim 13, wherein the plurality of pieces of real data comprise at least one piece of first data and at least one piece of second data; and the processing unit is configured to:
adjust the plurality of pieces of first simulation data based on the at least one piece of second data to obtain the plurality of pieces of second simulation data;
perform model training based on the at least one piece of first data and the plurality of pieces of first simulation data to obtain a second AI model; and
adjust the second AI model based on the at least one piece of second data and the plurality of pieces of second simulation data to obtain the first AI model.

15. The apparatus according to claim 14, wherein the obtaining unit is configured to:
create the simulation environment based on the at least one piece of first data; and
generate the plurality of pieces of first simulation data based on the simulation environment.

16. The apparatus according to claim 14 or 15, wherein the processing unit is configured to:
obtain a first adjustment model based on the at least one piece of second data and the plurality of pieces of first simulation data, wherein the first adjustment model is used to adjust a visual characteristic of simulation data toward a visual characteristic of the data describing the real environment; and
adjust visual characteristics of the plurality of pieces of first simulation data based on the first adjustment model to obtain the plurality of pieces of second simulation data.

17. The apparatus according to claim 16, wherein the processing unit is configured to:
adjust the visual characteristics of the plurality of pieces of first simulation data based on a second adjustment model to obtain a plurality of pieces of third simulation data;
determine, based on a first discriminator network, a first type of data comprised in a first data set, wherein the first type indicates whether the data is real data or simulation data, and the first data set comprises the at least one piece of second data and the plurality of pieces of third simulation data;
adjust a network parameter of the second adjustment model based on the first type of the data comprised in the first data set to obtain a third adjustment model; and
when the third adjustment model meets a first condition, determine the third adjustment model as the first adjustment model.

18. The apparatus according to claim 17, wherein the processing unit is further configured to:
when the third adjustment model does not meet the first condition, adjust a network parameter of the first discriminator network based on a second type of the at least one piece of second data and the first type of the data comprised in the first data set to obtain a second discriminator network, wherein the second type indicates that the at least one piece of second data is real data;
adjust the visual characteristics of the plurality of pieces of first simulation data based on the third adjustment model to obtain a plurality of pieces of fourth simulation data;
determine, based on the second discriminator network, a first type of data comprised in a second data set, wherein the second data set comprises the at least one piece of second data and the plurality of pieces of fourth simulation data;
adjust a network parameter of the third adjustment model based on the first type of the data comprised in the second data set to obtain a fourth adjustment model; and
when the fourth adjustment model meets the first condition, determine the fourth adjustment model as the first adjustment model.

19. The apparatus according to any one of claims 14 to 18, wherein the processing unit is configured to:
adjust a network parameter of the second AI model based on the at least one piece of second data and the plurality of pieces of second simulation data to obtain a third AI model, wherein features that are of the plurality of pieces of second simulation data and that are extracted based on the third AI model are closer to a feature of the at least one piece of second data than features that are of the plurality of pieces of second simulation data and that are extracted based on the second AI model; and
adjust a network parameter of the third AI model based on a third data set and label information of data in the third data set to obtain the first AI model, wherein the third data set comprises the at least one piece of second data and the plurality of pieces of second simulation data.

20. The apparatus according to claim 19, wherein the processing unit is configured to:
extract the feature of the at least one piece of second data and the features of the plurality of pieces of second simulation data based on the second AI model; and
adjust the network parameter of the second AI model based on the feature of the at least one piece of second data and the features of the plurality of pieces of second simulation data to obtain the third AI model.

21. The apparatus according to claim 20, wherein the processing unit is configured to:
annotate the plurality of pieces of second simulation data to obtain label information of the plurality of pieces of second simulation data;
annotate some second data in the at least one piece of second data to obtain label information of the some second data; and
extract the feature of the at least one piece of second data and the features of the plurality of pieces of second simulation data based on the second AI model, the label information of the some second data, and the label information of the plurality of pieces of second simulation data.

22. The apparatus according to claim 19 or 20, wherein the label information of the data in the third data set comprises label information of the at least one piece of second data and label information of the plurality of pieces of second simulation data; and
the processing unit is further configured to:
perform inference on the at least one piece of second data based on the third AI model to obtain the label information of the at least one piece of second data; and
annotate the plurality of pieces of second simulation data based on a multi-modal model to obtain the label information of the plurality of pieces of second simulation data.

23. The apparatus according to any one of claims 13 to 22, wherein the apparatus further comprises a receiving unit;
the receiving unit is configured to receive at least one piece of real data and label information of the at least one piece of real data that are sent by a terminal device, wherein the terminal device is located in the real environment, the at least one piece of real data is data collected by the terminal device in the real environment, and the label information of the at least one piece of real data is obtained by the terminal device by performing inference on the at least one piece of truth data based on the first AI model; and
the processing unit is further configured to adjust the first AI model based on the at least one piece of real data and the label information of the at least one piece of real data.

24. The apparatus according to any one of claims 13 to 23, wherein the plurality of pieces of real data comprise one or more of the following data: image data, radar data, object point cloud data, or object inertial measurement unit IMU data.

25. A computing device cluster, wherein the computing device cluster comprises at least one computing device, each device in the at least one computing device comprises at least one processor and at least one memory, the at least one memory stores computer-readable instructions, and the at least one processor executes the computer-readable instructions, so that the computing device cluster performs the method according to any one of claims 1 to 12.

26. A computer-readable storage medium, wherein the computer-readable storage medium stores a computer program; and when the computer program is executed by a computer, the method according to any one of claims 1 to 12 is implemented.

27. A computer program product, comprising a computer program, wherein when the computer program is executed by a processor, the method according to any one of claims 1 to 12 is implemented.
